(19) Europäisches Patentamt
European Patent Office
Office européen des brevets

(11) **EP 3 312 621 B1**

(12) **EUROPEAN PATENT SPECIFICATION**

(45) Date of publication and mention
of the grant of the patent:
**27.04.2022 Bulletin 2022/17**

(21) Application number: **15895653.2**

(22) Date of filing: **19.06.2015**

(51) International Patent Classification (IPC):
***G01R 31/52*** *(2020.01)*

(52) Cooperative Patent Classification (CPC):
**G01R 31/52; G01R 31/025**

(86) International application number:
**PCT/JP2015/067690**

(87) International publication number:
**WO 2016/203633 (22.12.2016 Gazette 2016/51)**

(54) **LEAK CURRENT DETECTING DEVICE**

LECKSTROMDETEKTIONSVORRICHTUNG

DISPOSITIF DE DÉTECTION DE COURANT DE FUITE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.04.2018 Bulletin 2018/17**

(73) Proprietor: **Mitsubishi Electric Corporation Chiyoda-ku Tokyo 100-8310 (JP)**

(72) Inventor: **HARADA, Koki Tokyo 100-8310 (JP)**

(74) Representative: **Diehl & Partner Patent- und Rechtsanwaltskanzlei mbB Erika-Mann-Straße 9 80636 München (DE)**

(56) References cited:
**EP-A1- 0 856 739        DE-A1- 3 642 136
DE-A1-102007 052 963    JP-A- H04 297 877
JP-A- 2009 229 211      JP-A- 2011 217 588
JP-A- 2011 217 588**

**Description**

TECHNICAL FIELD

The present invention relates to a leak current detecting device for detecting electric leak on an electric path, and in particular, relates to a leak current detecting device (hereinafter, referred to as an electric leak detecting device) for detecting electric leak on a single-phase two-wire electric path and on a three-phase three-wire electric path.

BACKGROUND ART

Leak currents include leak current due to ground electrostatic capacitance, and leak current (hereinafter, referred to as ground fault current Ior) that is due to insulation resistance to ground and is directly involved with the insulation resistance. A cause for electric leak fire or the like is the presence of the insulation resistance, and if the ground fault current Ior due to the insulation resistance can be accurately detected, the insulation state of the circuit can be checked, and thus a disaster such as electric leak fire can be avoided.

In a conventional electric leak detecting device, ground fault current on a single-phase two-wire electric path is calculated from a peak value of a zero-phase current waveform, and a phase difference between the zero-phase current waveform and a power supply voltage waveform.

That is, as shown in Patent Document 1, a peak value of zero-phase current Io, and a phase difference $\varphi$ between power supply voltage V and the zero-phase current Io, are detected, and the ground fault current Ior is calculated by the following calculation.

[Mathematical 1]

$$\mathrm{Ior} = \mathrm{Io}\, cos\varphi$$

In a three-phase three-wire electric path, if the three-wire cable lengths are equal to each other, and non-grounded electric paths have the same electrostatic capacitance C, a peak value of zero-phase current Io, and a phase difference $\varphi$ between the zero-phase current Io and inter-phase voltage V(R→T) between non-grounded phases (T phase - R phase), are detected, and the ground fault current Ior is calculated by the following calculation (see Patent Document 1 again).

[Mathematical 2]

$$\mathrm{Ior} = \frac{\mathrm{Io}\, sin\varphi}{cos30°}$$

(Inter-phase voltage V(R→T) is defined as V(R→T) = V(T phase) - V(R phase), where the arrow "→" from R to T denotes the vector direction.)

EP 0 856 739 A1 discloses a device for detecting the initiation of short-circuit conditions in an electrical network. The device comprises a current sensor adapted to provide an output signal proportional to the instantaneous current i(t) monitored by the sensor. The instantaneous current i(t) is the current flowing into the load of an electrical network. The device further comprises a differentiation means providing a differential value of the current sensor's output signal. In the processing and detection block 4, the digitized values of the current sensor's output signal and the current sensor's differentiated output signal are processed to obtain a normalized current I(t) based on the ratio of the reactive to the ohmic part of the load's impedance, the phase of the voltage, the frequency, and the normalization constant Io typically representing the nominal current characterizing the circuit breaker 12.

DE 36 42 136 A1 discloses an overcurrent trip using a sensor for detecting the derivation of the currents in each of the power lines, calculating the currents by multiplying the derivation of the currents with a constant time, summing up the products obtained, and comparing the sum to a threshold value.

DE 10 2007 02 963 A1 discloses a method for determining a short-circuit by determining the current and its derivation at regular intervals, transforming the results in a digital sequence of numbers, and comparing the sequence of numbers with a corresponding threshold value. Each number exceeding the threshold value is assigned a weighting factor with the weighting factors related to a certain time being summed up to form a first weighting sum. Consecutive weighting sums are than summed up to form a second weighting sum, whereby a short-circuit condition is assumed, when the second weighting sum exceeds a certain threshold.

CITATION LIST

PATENT DOCUMENT

Patent Document 1: Japanese Patent No. 4159590

SUMMARY OF THE INVENTION

PROBLEMS TO BE SOLVED BY THE INVENTION

However, in the conventional technique, since a peak value of zero-phase current is used for calculation of ground fault current, the detection speed is limited by the peak cycle of the zero-phase current, and the determination speed of the ground fault current calculation is slow, thus causing a problem of operation delay, in particular, in a device such as an earth leakage circuit breaker that requires high-speed ground fault current detection.

For example, in the case where, in an electric path with a power supply frequency of 50 Hz, an average value of peak values of zero-phase current for four times is used for calculation of ground fault current, a detection time of at least 40ms is needed for detecting the peak value of zero-phase current four times. However, according to the earth leakage circuit breaker standards IEC60947-2 and JIS C 8201-2-2, the maximum operation time in the case where leak current of 5I∆N occurs is prescribed as 40ms. Therefore, the conventional method cannot meet these standards.

The present invention has been made to solve the above problem, and an object of the present invention is to provide an electric leak detecting device capable of detecting ground fault current at a higher speed than in the conventional devices.

SOLUTION TO THE PROBLEMS

An electric leak detecting device according to the present invention includes: a current detection means for detecting zero-phase current on an electric path; a voltage detection means for detecting voltage on the electric path; a differentiation means for calculating a differential value of the zero-phase current on the basis of phase information about the voltage; and a leak current deriving means for deriving leak current on the basis of a value of the zero-phase current and the differential value.

EFFECT OF THE INVENTION

In the above configuration, the differential value of current is calculated on the basis of phase information about voltage, whereby leak current can be derived at a higher speed than in the conventional devices.

BRIEF DESCRIPTION OF THE DRAWINGS

[FIG. 1] FIG. 1 is a function block diagram of an electric leak detecting device in embodiment 1 of the present invention.
[FIG. 2A] FIG. 2A is a graph showing a simulation result in embodiment 1 of the present invention.
[FIG. 2B] FIG. 2B is an equivalent circuit diagram for simulation in embodiment 1 of the present invention.
[FIG. 3] FIG. 3 is a function block diagram of an electric leak detecting device in embodiment 2 of the present invention.
[FIG. 4A] FIG. 4A is a graph showing a simulation result in embodiment 2 of the present invention.
[FIG. 4B] FIG. 4B is an equivalent circuit diagram for simulation in embodiment 2 of the present invention.
[FIG. 5] FIG. 5 is a function block diagram of an electric leak detecting device in embodiment 3 of the present invention.
[FIG. 6] FIG. 6 is a graph showing a simulation result in embodiment 3 of the present invention.
[FIG. 7] FIG. 7 is a function block diagram of an electric leak detecting device in embodiment 4 of the present invention.
[FIG. 8] FIG. 8 is a graph showing a simulation result in embodiment 4 of the present invention.

DESCRIPTION OF EMBODIMENTS

Embodiment 1

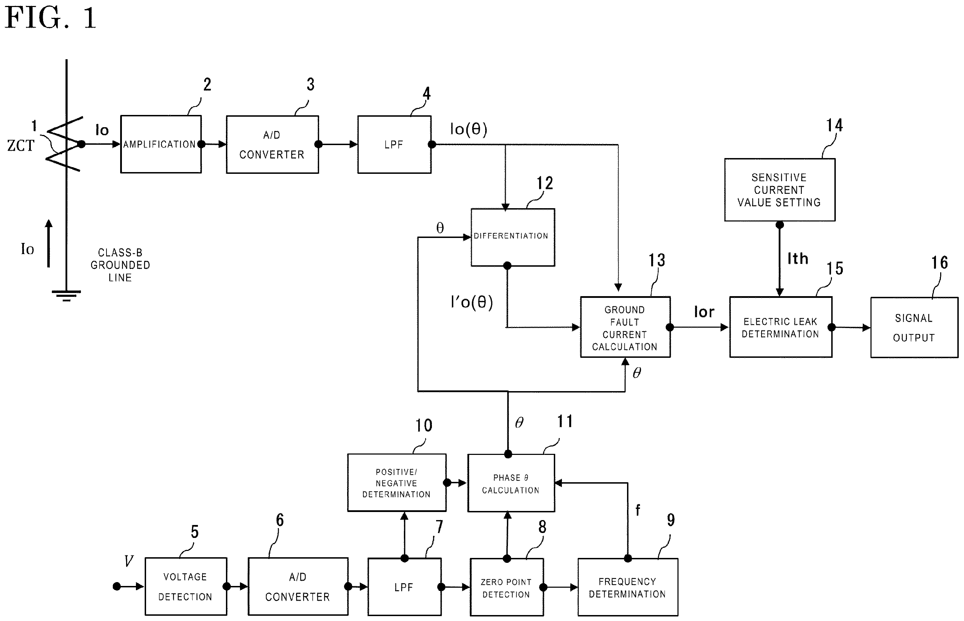

Hereinafter, an electric leak detecting device according to embodiment 1 of the present invention will be described in detail with reference to the drawings. FIG. 1 is a function block diagram of the electric leak detecting device according to embodiment 1 of the present invention, and shows a configuration for detecting electric leak on a single-phase two-wire electric path.

In FIG. 1, a zero-phase current transformer (hereinafter, referred to as ZCT) 1 is zero-phase current detection means for detecting zero-phase current Io flowing through a ground line which is class-B grounded. An amplification circuit 2 amplifies the zero-phase current Io detected by the ZCT 1.

An analog/digital converter (hereinafter, referred to as an A/D converter) 3 samples the zero-phase current Io amplified by the amplification circuit 2 and converts the same to a digital value. A low-pass filter (hereinafter, referred to as LPF) 4 eliminates a harmonic component from the zero-phase current Io converted to a digital value by the A/D converter 3, and outputs the sampling value that has undergone the elimination, as an instantaneous value Io(θ) of the zero-phase current Io.

On the other hand, a voltage detection circuit 5 detects power supply voltage V, and an A/D converter 6 converts the detected power supply voltage V to a digital value. The sampling timing here is the same as the timing in the A/D converter 3. A LPF 7 eliminates a harmonic component from the power supply voltage V converted to a digital value. A zero-cross-point detection circuit 8 detects a zero cross point cycle of power supply voltage V, and a frequency determination circuit 9 determines a frequency f of power supply voltage V on the basis of the detected zero cross point cycle.

Meanwhile, a positive/negative determination circuit 10 determines whether the output of the LPF 7 is positive or negative. A phase calculation unit 11 calculates a phase θ of the power supply voltage V on the basis of the positive/negative information, the zero cross point cycle, and the frequency f. A differentiation circuit 12 calculates an instantaneous value I'o(θ) of a differential of the zero-phase current on the basis of the phase θ outputted from the phase calculation unit 11 and the instantaneous value Io(θ) of the zero-phase current outputted from the LPF 4. A ground fault current calculation unit 13 calculates ground fault current Ior on the basis of the instantaneous value I'o(θ) of the differential, the instantaneous value Io(θ) of the zero-phase current, and the phase θ outputted from the phase calculation unit (11).

An electric leak determination unit 15 compares the ground fault current Ior outputted from the ground fault current calculation unit 13 with a sensitive current value Ith set by a sensitive current value setting unit 14, and determines that electric leak occurs if Ior ≥ Ith is satisfied. If it is determined that electric leak occurs, a signal output unit 16 outputs a signal to an external circuit such as a circuit breaker.

The configuration shown in the function block diagram in FIG. 1 is actually achieved by combination of an electric circuit and a microcomputer. In particular, the A/D converters, the LPFs, the determination circuits, the calculation circuits, and the like may be configured by software, using a microcomputer including a digital sigma A/D converter.

Next, a method for calculating the phase θ of the power supply voltage V by the phase calculation unit 11 described above will be described in detail.

For the phase θ, a zero cross point (θ = 0°) at which the power supply voltage V switches from negative to positive is used as a reference point. The zero cross point as a reference is calculated from the timing information about the zero cross point of the power supply voltage V, detected by the zero-cross-point detection circuit 8, and the positive/negative information about the power supply voltage V, detected by the positive/negative determination circuit 10.

A change amount Δθ = 2πfΔT, of the phase θ is accumulated every sampling period ΔT from the calculated reference point (θ = 0°), to calculate the phase θ as θ = Σ2πfΔT. It is noted that, as the frequency f of the power supply voltage V used for the above calculation, a value determined by the frequency determination circuit 9 is used.

The instantaneous value Io(θ) of the zero-phase current Io converted to a digital value by the A/D converter 3 can be represented by the following expression.

[Mathematical 3]

$$Io(\theta) = Ior \, sin\theta + Ioc \, cos\theta$$

In this expression, Ior is a peak value of ground fault current, and Ioc is a peak value of leak current due to a ground electrostatic capacitance.

Next, a method for deriving the instantaneous value I'o(θ) of the differential of the zero-phase current by the differentiation circuit 12 described above will be described in detail.

On the basis of a difference between the instantaneous value Io(θ) of the zero-phase current Io and the previous sampling value Io(θ - Δθ) as shown in Mathematical 4, and a change amount Δθ of the phase θ, the differentiation circuit 12 calculates the instantaneous value I'o(θ) of the differential of the zero-phase current as shown in Mathematical 5.

[Mathematical 4]

$$\Delta Io(\theta) = Io(\theta) - Io(\theta - \Delta\theta)$$

[Mathematical 5]

$$I'o(\theta) = \frac{\Delta Io(\theta)}{\Delta\theta}$$

The ground for the above formula is as shown below.

The difference $\Delta Io(\theta)$ between $Io(\theta)$ and the previous sampling value $Io(\theta - \Delta\theta)$ is represented by the following expression through Taylor expansion.

[Mathematical 6]

$$\Delta Io(\theta) = Io(\theta) - Io(\theta - \Delta\theta) = I'o(\theta)\Delta\theta - \frac{I''o(\theta)}{2}(\Delta\theta)^2 + \cdots$$

Here, when $\Delta\theta = 2\pi f\Delta T$ is small, i.e., when the sampling period $\Delta T$ is short, high-order terms can be ignored and thus the above expression can be approximated as shown by the following expression.

[Mathematical 7]

$$\frac{\Delta Io(\theta)}{\Delta\theta} \cong I'o(\theta) = Ior\,cos\theta - Ioc\,sin\theta$$

Next, the function of the ground fault current calculation unit 13 will be described in detail. The instantaneous value $Io(\theta)$ of the zero-phase current Io and the instantaneous value $I'o(\theta)$ of the differential of the zero-phase current Io calculated as described above are inputted to the ground fault current calculation unit 13, in which $Io(\theta)$ is multiplied by $sin\theta$ and $I'o(\theta)$ is multiplied by $cos\theta$.

$Io(\theta)sin\theta$ and $I'o(\theta)cos\theta$ are respectively represented as follows.

[Mathematical 8]

$$Io(\theta)sin\theta = Ior\,sin^2\theta + Ioc\,sin\theta cos\theta$$

[Mathematical 9]

$$I'o(\theta)cos\theta = Ior\,cos^2\theta - Ioc\,sin\theta cos\theta$$

By adding the above two expressions, the following expression is obtained.

[Mathematical 10]

$$Io(\theta)sin\theta + I'o(\theta)cos\theta = Ior$$

Thus, a peak value of the ground fault current Ior can be calculated.

A specific example will be described using a waveform diagram.

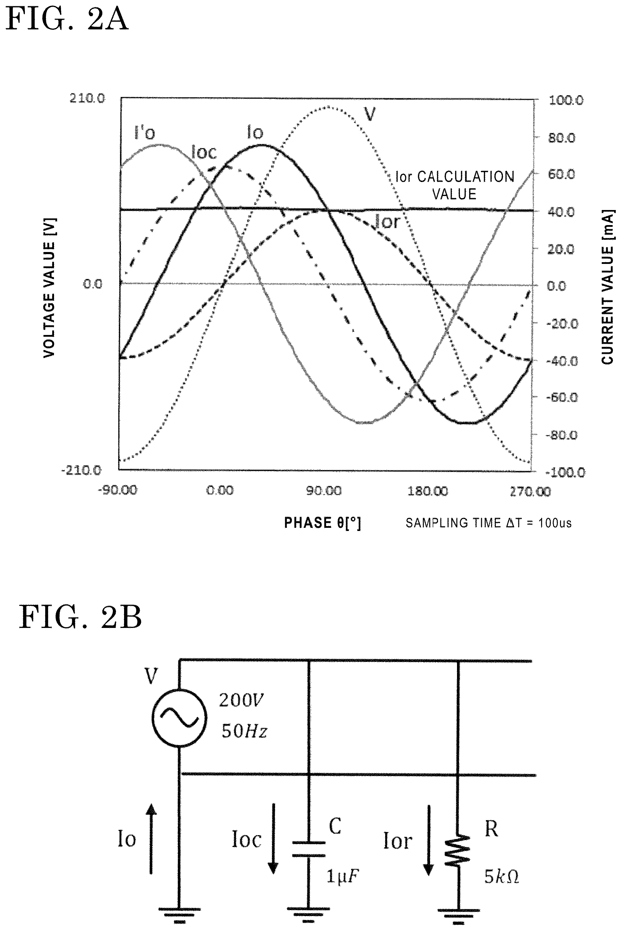

FIG. 2A is a graph showing a simulation result in the case where electric leak occurs on a single-phase two-wire electric path with a frequency of 50 Hz. The vertical left axis indicates a voltage value and the unit thereof is volt. The vertical right axis indicates a current value and the unit thereof is mA. The horizontal axis indicates the phase $\theta$ and the unit thereof is degree. The sampling period is $\Delta T = 100\mu s$. As shown in an equivalent circuit in FIG. 2B, circuit constants used in the simulation are as follows: a ground electrostatic capacitance C is $1\mu F$, a ground fault resistance R is 5kQ, and power supply voltage V is 200V.

Next, the ground fault current Ior is obtained through calculation on the basis of only the instantaneous value $Io(\theta)$ of the zero-phase current Io, the previous sampling value $Io(\theta - \Delta\theta)$, and the phase information. For example, in the case of $\theta = 72.0°$, the instantaneous value of the zero-phase current Io is represented as follows.

[Mathematical 11]

$$Io(72.0°) = 57.46mA$$

In the case where the power supply frequency f is 50Hz and the sampling period is 100μs, Δθ is 1.8° and therefore the previous sampling value Io(θ - Δθ) is represented as follows.

[Mathematical 12]

$$Io(70.2°) = 58.90mA$$

By substituting these values into the above-described expression for calculating the instantaneous value I'o(θ) of the differential of the zero-phase current, the following value is obtained.

[Mathematical 13]

$$I'o(72.0°) = -46.47mA$$

By substituting this value into the above-described expression for calculating the peak value of the ground fault current Ior, Ior = 40.29mA (true value is 40.00mA) is obtained.

The calculation value of Ior calculated by the above method is plotted for every θ, thereby obtaining the Ior calculation value shown in FIG. 2A, and it is found that, at any phase θ, electric leak can be detected as a value close to the actual ground fault current value Ior = 40mA. It is noted that the differential value of the zero-phase current may be calculated by digital calculation using a microcomputer as described above, or may be directly calculated by configuring a differentiation circuit using an analog circuit.

Thus, according to the configuration of embodiment 1, in electric leak detection on a single-phase two-wire electric path, the ground fault current value can be calculated from the zero-phase current and the differential value of the zero-phase current at any phase angle, and this calculation can be performed every sampling period. Therefore, as compared to the conventional detection time which is 10ms at the shortest if the power supply frequency is 50Hz (the detection time is proportional to the number of times of averaging, and in principle, the detection time is 10ms at the shortest), the detection can be performed every sampling period of 100μs, and thus it is possible to accurately perform electric leak determination immediately after occurrence of electric leak. It is noted that, by shortening the sampling period ΔT or including high-order terms of Taylor expansion described above in the calculation, it is possible to make further improvement in detection accuracy and detection time.

Embodiment 2

In embodiment 1, the configuration for detecting electric leak on a single-phase two-wire electric path has been shown. In the present embodiment, detection of electric leak on a three-phase three-wire electric path connected in a delta manner will be described.

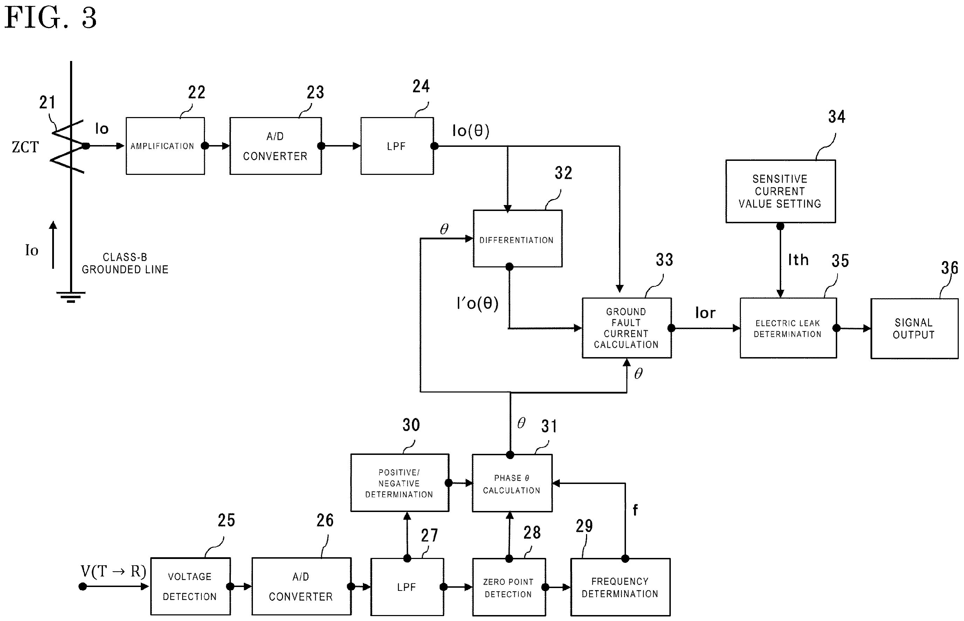

FIG. 3 is a function block diagram showing the present embodiment. Here, it is assumed that the three-wire cable lengths are equal to each other and non-grounded electric paths have the same electrostatic capacitance C.

In FIG. 3, a ZCT 21 is zero-phase current detection means for detecting zero-phase current Io flowing through a ground line which is class-B grounded. An amplification circuit 22 amplifies the zero-phase current Io detected by the ZCT 21.

An A/D converter 23 samples the zero-phase current Io amplified by the amplification circuit 22 and converts the same to a digital value. A LPF 24 eliminates a harmonic component from the zero-phase current Io converted to a digital value by the A/D converter 23, and outputs the sampling value that has undergone the elimination, as an instantaneous value Io(θ) of the zero-phase current Io.

On the other hand, a voltage detection circuit 25 detects inter-phase voltage V(T→R) between non-grounded phases (R phase - T phase), and an A/D converter 26 converts the detected inter-phase voltage V(T→R) to a digital value. The sampling timing here is the same as the timing in the A/D converter 23. A LPF 27 eliminates a harmonic component from the inter-phase voltage V(T→R) converted to a digital value. A zero-cross-point detection circuit 28 detects a zero cross point cycle of the inter-phase voltage V(T→R), and a frequency determination circuit 29 determines a frequency f of the inter-phase voltage V(T→R) on the basis of the detected zero cross point cycle.

Meanwhile, a positive/negative determination circuit 30 determines whether the output of the LPF 27 is positive or negative. A phase calculation unit 31 calculates a phase θ of the inter-phase voltage V(T→R) on the basis of the positive/negative information, the zero cross point cycle, and the frequency f. A differentiation circuit 32 calculates an instantaneous value I'o(θ) of a differential of the zero-phase current on the basis of the phase θ outputted from the phase calculation unit 31 and the instantaneous value Io(θ) of the zero-phase current outputted from the LPF 24. A ground fault current calculation unit 33 calculates ground fault current Ior on the basis of the instantaneous value I'o(θ) of the differential, the instantaneous value Io(θ) of the zero-phase current, and the phase θ outputted from the phase calculation unit 31.

An electric leak determination unit 35 compares the ground fault current Ior outputted from the ground fault current calculation unit 33 with a sensitive current value Ith set by a sensitive current value setting unit 34, and determines that electric leak occurs if Ior ≥ Ith is satisfied. If it is determined that electric leak occurs, a signal output unit 36 outputs a signal to an external circuit such as a circuit breaker.

The configuration shown in the function block diagram in FIG. 3 is actually achieved by combination of an electric circuit and a microcomputer. In particular, the A/D converters, the LPFs, the determination circuits, the calculation circuits, and the like may be configured by software, using a microcomputer including a digital sigma A/D converter.

Next, a method for calculating the phase θ of the inter-phase voltage V(T→R) by the phase calculation unit 31 described above will be described in detail.

For the phase θ, a zero cross point (θ = θ°) at which the inter-phase voltage V(T→R) switches from negative to positive is used as a reference point. The zero cross point as a reference is calculated from the timing information about the zero cross point of the inter-phase voltage V(T→R), detected by the zero-cross-point detection circuit 28, and the positive/negative information about the inter-phase voltage V(T→R), detected by the positive/negative determination circuit 30.

A change amount Δθ = 2πfΔT, of the phase θ is accumulated every sampling period ΔT from the calculated reference point (θ = θ°), to calculate the phase θ as θ = Σ2πfΔT. It is noted that, as the frequency f of the inter-phase voltage V(T→R) used for the above calculation, a value determined by the frequency determination circuit 29 is used.

The instantaneous value Io(θ) of the zero-phase current Io converted to a digital value can be represented by the following expression, using the above phase θ.

[Mathematical 14]

$$Io(\theta) = IorR \, \cos(\theta - 30°) + IorT \, \cos(\theta + 30°) - Ioc \, \sin\theta$$

In this expression, IorR is a peak value of ground fault current for R phase, IorT is a peak value of ground fault current for T phase, and Ioc is a peak value of leak current due to a ground electrostatic capacitance.

The instantaneous value I'o(θ) of a differential of the zero-phase current Io, which is derived by the differentiation circuit 32, can be approximated as shown by the following expression through derivation by Taylor expansion as described in embodiment 1.

[Mathematical 15]

$$\frac{\Delta Io(\theta)}{\Delta\theta} \cong I'o(\theta) = -IorR \, \sin(\theta - 30°) - IorT \, \sin(\theta + 30°) - Ioc \, \cos\theta$$

Next, the function of the ground fault current calculation unit 33 will be described in detail. The instantaneous value Io(θ) of the zero-phase current Io and the instantaneous value I'o(θ) of the differential of the zero-phase current, calculated as described above, are inputted to the ground fault current calculation unit 33, in which Io(θ) is multiplied by cosθ and I'o(θ) is multiplied by sinθ.

Io(θ)cosθ and I'o(θ)sinθ are respectively represented as follows.

[Mathematical 16]

$$Io(\theta)cos\theta = IorR \, \cos\theta \, \cos(\theta - 30°) + IorT \, \cos\theta \, \cos(\theta +$$

$$30°) - Ioc \, \sin\theta \, \cos\theta$$

[Mathematical 17]

$$I'o(\theta) \sin\theta = -IorR \sin\theta \sin(\theta - 30°) - IorT \sin\theta \sin(\theta +$$

$$30°) - Ioc \sin\theta \cos\theta$$

A difference therebetween is represented as follows.

[Mathematical 18]

$$Io(\theta)cos\theta - I'o(\theta) \sin\theta = IorR \cos 30° + IorT \cos 30°$$

Thus, the following expression is obtained.

[Mathematical 19]

$$Ior \equiv IorR + IorT = \frac{Io(\theta) \cos\theta - I'o(\theta) \sin\theta}{\cos 30°}$$

In this way, a peak value of the ground fault current Ior can be calculated.

A specific example will be described using a waveform diagram.

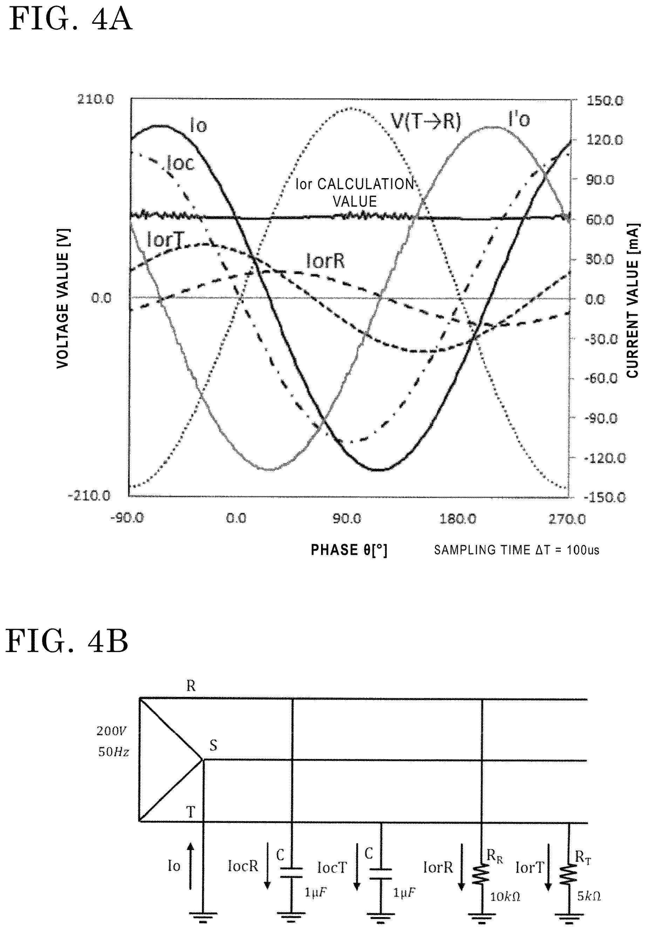

FIG. 4A is a graph showing a simulation result in the case where electric leak occurs on a three-phase three-wire electric path with a frequency of 50 Hz. The vertical left axis indicates a voltage value and the unit thereof is volt. The vertical right axis indicates a current value and the unit thereof is mA. The horizontal axis indicates the phase θ and the unit thereof is degree. The sampling period is ΔT = 100μs. As shown in an equivalent circuit in FIG. 4B, circuit constants used in the simulation are as follows: a ground electrostatic capacitance CR for R phase is 1μF, a ground electrostatic capacitance CT for T phase is 1μF, a ground fault resistance RR for R phase is 10kΩ, a ground fault resistance RT for T phase is 5kΩ, and power supply voltage V is 200V.

Next, as in embodiment 1, the ground fault current Ior is obtained through calculation on the basis of only the instantaneous value Io(θ) of the zero-phase current Io, the previous sampling value Io(θ - Δθ), and the phase information. For example, in the case of θ = 72.0°, the instantaneous value of the zero-phase current Io is represented as follows.

[Mathematical 20]

$$Io(72.0°) = -94.36mA$$

In the case where the power supply frequency f is 50Hz and the sampling period is 100μs, Δθ is 1.8° and therefore the previous sampling value Io(θ - Δθ) is represented as follows.

[Mathematical 21]

$$Io(70.2°) = -91.42mA$$

By substituting these values into the above-described expression for calculating the instantaneous value I'o(θ) of the differential of the zero-phase current, the following value is obtained.

[Mathematical 22]

$$I'o(72.0°) = -90.40mA$$

By substituting this value into the above-described expression for calculating the peak value of the ground fault current Ior, Ior = 61.37mA (true value is 60.00mA) is obtained.

The calculation value of Ior calculated by the above method is plotted for every θ, thereby obtaining the Ior calculation value shown in FIG. 4A, and it is found that, at any phase θ, electric leak can be detected as a value close to the actual ground fault current value Ior = 60mA. It is noted that the differential value of the zero-phase current may be calculated by digital calculation using a microcomputer as described above, or may be directly calculated by configuring a differentiation circuit using an analog circuit.

Thus, according to the configuration of embodiment 2, in electric leak detection on a three-phase three-wire electric path connected in a delta manner, the ground fault current value can be calculated from the zero-phase current and the differential value of the zero-phase current at any phase angle, and this calculation can be performed every sampling period. Therefore, as compared to the conventional detection time which is 10ms at the shortest if the power supply frequency is 50Hz (the detection time is proportional to the number of times of averaging, and in principle, the detection time is 10ms at the shortest), the detection can be performed every sampling period of 100μs, and thus it is possible to accurately perform electric leak determination immediately after occurrence of electric leak. It is noted that, by shortening the sampling period ΔT or including high-order terms of Taylor expansion described above in the calculation, it is possible to make further improvement in detection accuracy and detection time.

Embodiment 3

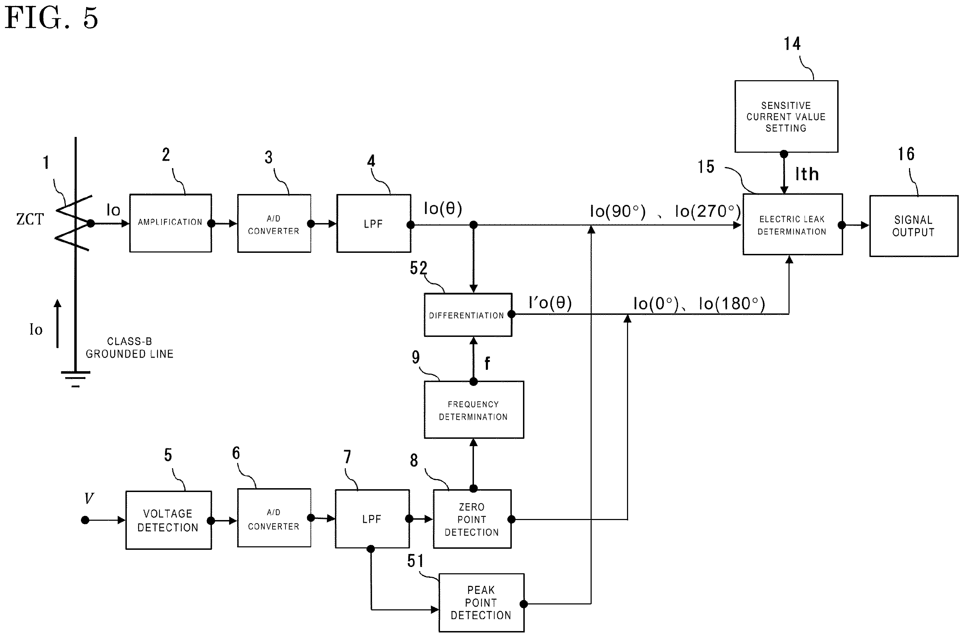

In embodiments 1 and 2, both detection accuracy and detection time of electric leak detection are significantly improved. FIG. 5 shows an electric leak detecting device having a detection circuit configuration simplified in consideration of the manufacturing cost. FIG. 5 is a function block diagram of an electric leak detecting device according to embodiment 3 of the present invention, and shows a configuration for detecting electric leak on a single-phase two-wire electric path. In FIG. 5, the same reference characters as those in FIG. 1 indicate the same or corresponding functions. The configuration shown in the function block diagram in FIG. 5 is actually achieved by combination of an electric circuit and a microcomputer. In particular, the A/D converters, the LPFs, the determination circuits, the calculation circuits, and the like may be configured by software, using a microcomputer including a digital sigma A/D converter.

In FIG. 5, output of the LPF 7 is inputted to a peak point detection circuit 51, which detects a peak point of the power supply voltage V. At the timing when the peak point detection circuit 51 detects the peak point, the instantaneous value Io(θ) of the zero-phase current Io becomes equal to the ground fault current Ior.

That is, the timing of detecting the peak point is when the phase θ of the power supply voltage V is θ = 90° or 270°. These values are substituted into the following expression representing the instantaneous value Io(θ) of the zero-phase current Io described in embodiment 1.

[Mathematical 23]

$$\mathrm{Io}(\theta) = \mathrm{Ior}\, sin\theta + \mathrm{Ioc}\, cos\theta$$

Thus, the following expressions are obtained.

[Mathematical 24]

$$\mathrm{Io}(90°) = \mathrm{Ior}$$

[Mathematical 25]

$$\mathrm{Io}(270°) = -\mathrm{Ior}$$

The instantaneous value I'o(θ) of a differential of the zero-phase current Io, calculated by a differentiation circuit 52, becomes equal to the ground fault current Ior at a timing when the zero-cross-point detection circuit 8 detects a zero cross point.

That is, the timing of detecting the zero cross point is when the phase θ of the power supply voltage V is θ = 0° or 180°. These values are substituted into the following expression representing the instantaneous value I'o(θ) of the differential of the zero-phase current Io described in embodiment 1.

[Mathematical 26]

$$\frac{\Delta \text{Io}(\theta)}{\Delta \theta} \cong \text{I}'\text{o}(\theta) = \text{Ior}\,\cos\theta - \text{Ioc}\,\sin\theta$$

Thus, the following expressions are obtained.

[Mathematical 27]

$$\text{I}'\text{o}(0°) = \text{Ior}$$

[Mathematical 28]

$$\text{I}'\text{o}(180°) = -\text{Ior}$$

In embodiment 1, $\Delta\theta$ needed as input to the differentiation circuit 52 is calculated by the phase calculation unit 11. In the present embodiment, the differentiation circuit 52 calculates a change amount $\Delta\theta = 2\pi f \Delta T$ of the phase $\theta$ every sampling period $\Delta T$ from the reference point ($\theta = 0°$).

A specific example will be described using a waveform diagram.

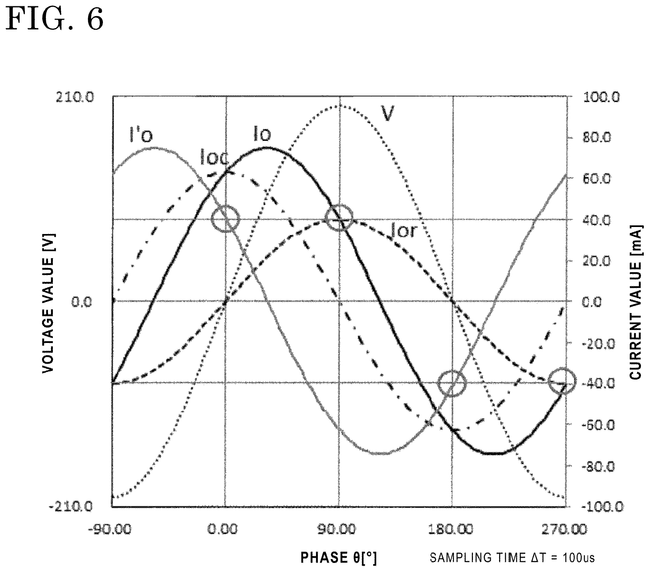

FIG. 6 is a graph showing a simulation result in the case where electric leak occurs on a single-phase two-wire electric path with a frequency of 50 Hz. The vertical left axis indicates a voltage value and the unit thereof is volt. The vertical right axis indicates a current value and the unit thereof is mA. The horizontal axis indicates the phase $\theta$ and the unit thereof is degree. The sampling period is $\Delta T = 100\mu s$. Circuit constants used in the simulation are the same as those in the equivalent circuit in FIG. 2B, i.e., a ground electrostatic capacitance C is $1\mu F$, a ground fault resistance R is $5k\Omega$, and power supply voltage V is 200V.

Focusing on the zero-phase current Io, it is found that Io coincides with the actual peak value 40mA of the ground fault current at peak points $\theta = 90°$, $270°$ of the power supply voltage V.

Focusing on the differential value I'o of the zero-phase current, it is found that I'o coincides with the actual peak value 40mA of the ground fault current at zero cross points $\theta = 0°$, $180°$ of the power supply voltage V.

Thus, according to the configuration of embodiment 3, a zero cross point as well as a peak point of the power supply voltage can be used for detection of ground fault current on a single-phase two-wire electric path, in a simple configuration using a differentiation circuit. Therefore, detection time can be shortened to be halved as compared to the conventional device. It is noted that the differentiation circuit may be configured by software using a microcomputer, or may be configured by an analog circuit.

Embodiment 4

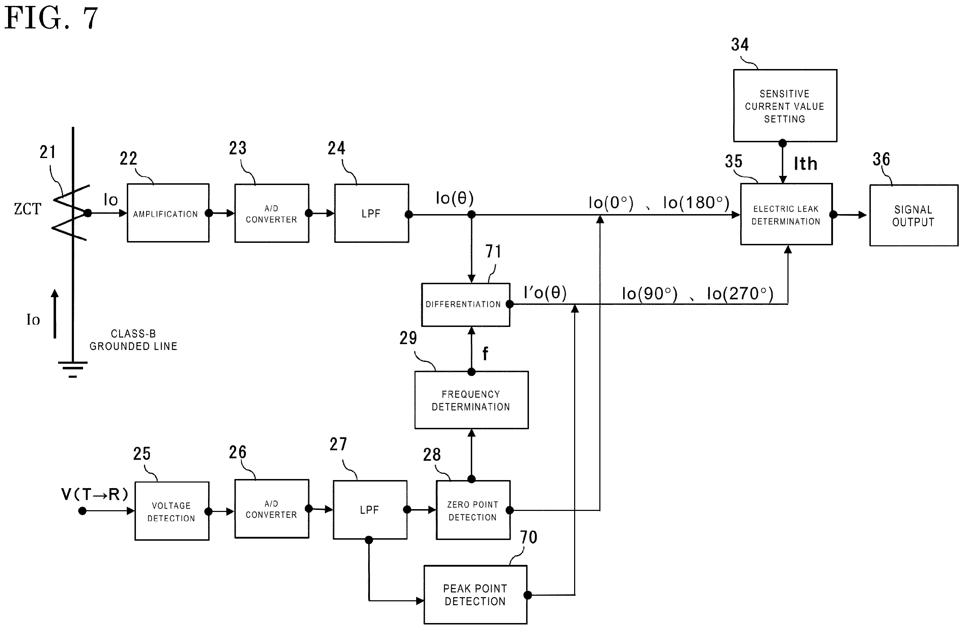

In the present embodiment, the configuration of embodiment 3 is applied to a three-phase three-wire electric path. FIG. 7 is a function block diagram of an electric leak detecting device according to embodiment 4 of the present invention. In FIG. 7, the same reference characters as those in FIG. 3 indicate the same or corresponding functions. The configuration shown in the function block diagram in FIG. 7 is actually achieved by combination of an electric circuit and a microcomputer. In particular, the A/D converters, the LPFs, the determination circuits, the calculation circuits, and the like may be configured by software, using a microcomputer including a digital sigma A/D converter.

In FIG. 7, output of the LPF 27 is inputted to the zero-cross-point detection circuit 28, and a value obtained by dividing the instantaneous value Io($\theta$) of the zero-phase current Io by cos30° becomes equal to the ground fault current Ior at the timing when the zero-cross-point detection circuit 28 detects the zero cross point.

That is, the timing of detecting the zero cross point is when the phase $\theta$ of the inter-phase voltage V(T-R) is $\theta = 0°$ or 180°. These values are substituted into the following expression representing the instantaneous value Io($\theta$) of the zero-phase current Io described in embodiment 2.

[Mathematical 29]

$$\text{Io}(\theta) = \text{IorR}\,\cos(\theta - 30°) + \text{IorT}\,\cos(\theta + 30°) - \text{Ioc}\,\sin\theta$$

Thus, the following expressions are obtained.

[Mathematical 30]

$$Io(0°) = IorR \cos 30° + IorT \cos 30°$$

[Mathematical 31]

$$Io(180°) = -IorR \cos 30° - IorT \cos 30°$$

Values obtained by dividing the above expressions by cos30° are equal to a total value Ior = IorR + IorT of the ground fault currents for non-grounded phases.

Similarly, output of the LPF 27 is inputted to a peak point detection circuit 70, and a value obtained by dividing, by cos30°, the instantaneous value I'o($\theta$) of a differential of the zero-phase current Io calculated by a differentiation circuit 71, is equal to the ground fault current Ior.

That is, the timing of detecting the peak point is when the phase $\theta$ of the inter-phase voltage V(T→R) is $\theta$ = 90° or 270°. These values are substituted into the following expression representing the instantaneous value I'o($\theta$) of the differential of the zero-phase current Io described in embodiment 2.

[Mathematical 32]

$$\frac{\Delta Io(\theta)}{\Delta\theta} \cong I'o(\theta) = -IorR \ \sin(\theta - 30°) - IorT \ \sin(\theta + 30°) - Ioc \ \cos\theta$$

Thus, the following expressions are obtained.

[Mathematical 33]

$$I'o(90°) = -IorR \cos 30° - IorT \cos 30°$$

[Mathematical 34]

$$I'o(270°) = IorR \cos 30° + IorT \cos 30°$$

Values obtained by dividing these values by cos30° are equal to a total value Ior = IorR + IorT of ground fault currents for non-grounded phases.

In embodiment 3, $\Delta\theta$ needed as input to the differentiation circuit 71 is calculated by the phase calculation unit 31. In the present embodiment, the differentiation circuit 71 calculates a change amount $\Delta\theta = 2\pi f\Delta T$ of the phase $\theta$ every sampling period $\Delta T$ from the reference point ($\theta$ = 0°).

A specific example will be described using a waveform diagram.

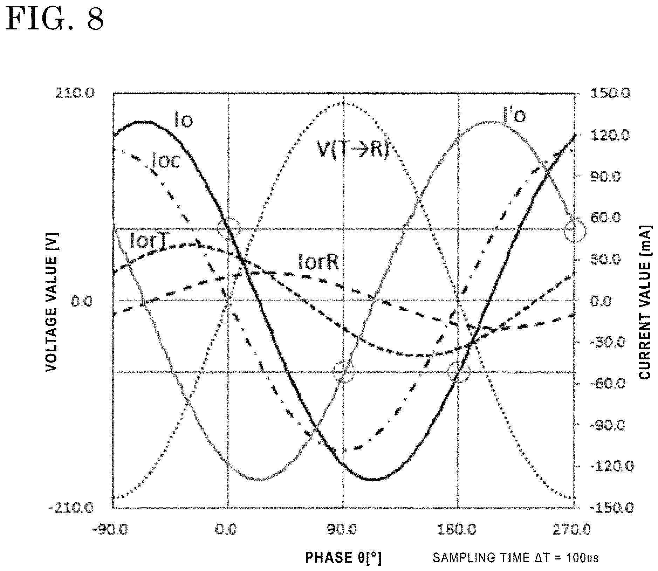

FIG. 8 is a graph showing a simulation result in the case where electric leak occurs on a three-phase three-wire electric path with a frequency of 50 Hz. The vertical left axis indicates a voltage value and the unit thereof is volt. The vertical right axis indicates a current value and the unit thereof is mA. The horizontal axis indicates the phase $\theta$ and the unit thereof is degree. The sampling period is $\Delta T$ = 100$\mu$s. Circuit constants used in the simulation are the same as those in the equivalent circuit in FIG. 4B, i.e., a ground electrostatic capacitance CR for R phase is 1$\mu$F, a ground electrostatic capacitance CT for T phase is 1$\mu$F, a ground fault resistance RR for R phase is 10k$\Omega$, a ground fault resistance RT for T phase is 5k$\Omega$, and power supply voltage V is 200V.

Focusing on the zero-phase current Io, it is found that, at zero cross points $\theta$ = 0°, 180° of the inter-phase voltage V(T→R), Io coincides with a value shown by the following expression, which is obtained by multiplying the actual total value 60mA of ground fault currents for non-grounded phases by cos30°.

[Mathematical 35]

$$Ior \cos 30° = 51.96 \ mA$$

Focusing on the differential value I'o of the zero-phase current, it is found that, at peak points θ = 90°, 270° of the inter-phase voltage V(T→R), I'o coincides with a value shown by the following expression, which is obtained by multiplying the actual total value 60mA of ground fault currents for non-grounded phases by cos30°.

[Mathematical 36]

$$\text{Ior}\cos 30° = 51.96 \text{ mA}$$

Thus, according to the configuration of embodiment 4, a zero cross point as well as a peak value of the inter-phase voltage can be used for detection of ground fault currents for non-grounded phases, in a simple configuration using a differentiation circuit. Therefore, detection time can be shortened to be halved as compared to the conventional device.

It is noted that, within the scope of the present invention, the above embodiments may be freely combined with each other, or each of the above embodiments may be modified or simplified as appropriate.

DESCRIPTION OF THE REFERENCE CHARACTERS

| | |
|---|---|
| 1 | ZCT |
| 2, 22 | amplification circuit |
| 3, 6, 23, 26 | A/D converter |
| 4, 7, 24, 27 | LPF |
| 5, 25 | voltage detection circuit |
| 8, 28 | zero-cross-point detection circuit |
| 9, 29 | frequency determination circuit |
| 10, 30 | positive/negative determination circuit |
| 11, 31 | phase calculation unit |
| 12, 32, 52, 71 | differentiation circuit |
| 13, 33 | ground fault current calculation unit |
| 14, 34 | sensitive current value setting unit |
| 15, 35 | electric leak determination unit |
| 16, 36 | signal output unit |
| 51, 70 | peak point detection circuit |

**Claims**

1. A leak current detecting device comprising:

    a zero-phase current detection means (8, 28) for detecting zero-phase current on an electric path;
    a voltage detection means (1, 21) for detecting voltage on the electric path;
    a differentiation means (12, 32, 52, 71) for calculating a differential value of the zero-phase current on the basis of phase information about the voltage; and
    a leak current deriving means (13, 33, 8, 28, 51, 70) for deriving leak current on the basis of a value of the zero-phase current and the differential value.

2. The leak current detecting device according to claim 1, wherein
    the differentiation means (12, 32) samples the voltage every sampling period and converts the sampled voltage to a digital value, accumulates a phase change amount for every sampling period from a reference point at which the voltage value converted to the digital value switches from negative to positive, and calculates the differential value of the zero-phase current.

3. The leak current detecting device according to any one of claims 1 or 2, further comprising an electric leak determination means (15, 35) for performing electric leak determination by comparing the leak current with a reference value.

**Patentansprüche**

1. Leckstrom-Erfassungsvorrichtung, aufweisend:

   ein Nullphasenstrom-Erfassungsmittel (8, 28) zum Erfassen von Nullphasenstrom auf einem elektrischen Pfad;
   ein Spannungs-Erfassungsmittel (1, 21) zum Erfassen von Spannung auf dem elektrischen Pfad;
   ein Differenzierungsmittel (12, 32, 52, 71) zur Berechnung eines Differentialwerts des Nullphasenstroms auf der Grundlage von Phaseninformationen über die Spannung; und
   ein Leckstrom-Herleitmittel (13, 33, 8, 28, 51, 70) zum Herleiten des Leckstroms auf der Grundlage eines Wertes des Nullphasenstroms und des Differentialwerts.

2. Leckstrom-Erfassungsvorrichtung nach Anspruch 1, wobei das Differenzierungsmittel (12, 32) die Spannung in jeder Abtastperiode abtastet und die abgetastete Spannung in einen Digitalwert umwandelt, ab einem Bezugspunkt, an dem der in den Digitalwert umgewandelte Spannungswert von negativ zu positiv wechselt, einen Phasenänderungsbetrag für jede Abtastperiode akkumuliert, und den Differentialwert des Nullphasenstroms berechnet.

3. Leckstrom-Erfassungsvorrichtung nach einem der Ansprüche 1 oder 2, weiter aufweisend ein Elektroleck-Bestimmungsmittel (15, 35) zur Durchführung einer Elektroleck-Bestimmung durch Vergleich des Leckstroms mit einem Referenzwert.


**Revendications**

1. Dispositif de détection de courant de fuite comprenant :

   des moyens de détection de courant de phase zéro (8, 28) pour détecter un courant de phase zéro sur un chemin électrique ;
   des moyens de détection de tension (1, 21) pour détecter une tension sur le chemin électrique ;
   des moyens de différentiation (12, 32, 52, 71) pour calculer une valeur différentielle du courant de phase zéro sur la base d'informations de phase concernant la tension ; et
   des moyens de dérivation de courant de fuite (13, 33, 8, 28, 51, 70) pour dériver le courant de fuite sur la base d'une valeur du courant de phase zéro et de la valeur différentielle.

2. Dispositif de détection de courant de fuite selon la revendication 1, dans lequel les moyens de différentiation (12, 32) échantillonnent la tension à chaque période d'échantillonnage et convertissent la tension échantillonnée en une valeur numérique, accumulent un degré de changement de phase pour chaque période d'échantillonnage à partir d'un point de référence auquel la valeur de tension convertie en valeur numérique passe de négative à positive, et calculent la valeur différentielle du courant de phase zéro.

3. Dispositif de détection de courant de fuite selon l'une quelconque des revendications 1 ou 2, comprenant en outre des moyens de détermination de fuite électrique (15, 35) pour réaliser une détermination de fuite électrique en comparant le courant de fuite à une valeur de référence.

# FIG. 1

EP 3 312 621 B1

# FIG. 2A

VOLTAGE VALUE [V]

CURRENT VALUE [mA]

PHASE θ[°]     SAMPLING TIME ΔT = 100us

# FIG. 2B

## FIG. 3

EP 3 312 621 B1

## FIG. 4A

## FIG. 4B

# FIG. 5

EP 3 312 621 B1

# FIG. 6

# FIG. 7

EP 3 312 621 B1

FIG. 8

PHASE θ[°]　　　　SAMPLING TIME ΔT = 100us

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0856739 A1
- DE 3642136 A1
- DE 10200702963 A1
- JP 4159590 B